# FASCICULE DE BREVET EUROPEEN

(11) **EP 2 893 566 B1**
(45) Date de publication et mention de la délivrance du brevet: **18.05.2016**
(21) Numéro de dépôt: 12775742.5
(22) Date de dépôt: 05.09.2012
(51) Int. Cl.: H01L 21/337, H01L 29/808

(54) **PROCEDE DE FABRICATION D'UN TRANSISTOR A EFFET DE CHAMP A JONCTION JFET**
VERFAHREN ZUR HERSTELLUNG EINES ÜBERGANGSFELDEFFEKTTRANSISTORS (JFET)
METHOD OF PRODUCING A JUNCTION FIELD-EFFECT TRANSISTOR (JFET)

(43) Date de publication de la demande: 15.07.2015
(73) Titulaire: Institut National des Sciences Appliquées de Lyon, 69100 Villeurbanne (FR); Université Claude Bernard Lyon 1, 69100 Villeurbanne (FR); Centre National de la Recherche Scientifique (CNRS), 75016 Paris (FR); Ecole Centrale de Lyon, 69134 Ecully (FR); Consejo Superior De Investigaciones Científicas (CSIC), 28006 Madrid (ES)
(72) Inventeur: TOURNIER, Dominique, F-69009 Lyon (FR); CHEVALIER, Florian, F-42000 Saint Etienne (FR); GODIGNON, Philippe, E-08197 Barcelona (ES); MILLAN, José, E-08208 Barcelona (ES)
(74) Mandataire: Regimbeau
(86) Numéro de dépôt international: PCT/FR2012/051983
(87) Numéro de publication internationale: WO 2014/037628

(56) Documents cités:
- EP-A2- 1 699 083
- US-A- 5 753 938
- US-A1- 2004 135 178
- US-A1- 2010 078 754
- US-A1- 2012 104 467
- LI S Y ET AL: "A STATIC INDUCTION TRANSISTOR WITH INSULATOR COVER-GARE AND WITH TRIODE-LIKE I-V CGARACTERISTICS", SOLID STATE ELECTRONICS, ELSEVIER SCIENCE PUBLISHERS, BARKING, GB, vol. 33, no. 3, 1 mars 1990 (1990-03-01), pages 345-349, XP000127562, ISSN: 0038-1101, DOI: 10.1016/0038-1101(90)90199-O

## Description

### DOMAINE TECHNIQUE

La présente invention concerne le domaine technique des transistors à effet de champ vertical et/ou quasi-vertical, et notamment des transistors à effet de champ à jonction (ci-après dénommés « JFET », acronyme de l'expression anglo-saxonne « *Junction Field Effect Transistor* »)*.*

### PRESENTATION DE L'ART ANTERIEUR

Un transistor JFET de puissance est un transistor à effet de champ vertical ou quasi-vertical utilisé en tant qu'interrupteur commandé de puissance.

Un transistor à effet de champ vertical se distingue d'un transistor à effet de champ classique par le fait que le canal conducteur du transistor s'étend perpendiculairement à la surface du substrat sur lequel est fabriqué le transistor.

Un transistor à effet de champ quasi-vertical se distingue d'un transistor à effet de champ vertical par le fait que le canal conducteur du transistor s'étend perpendiculairement à la surface du substrat sur lequel est fabriqué le transistor, et que la couche comportant le canal conducteur est disposée sur un substrat semi-isolant (SOI, GaN/Si par exemple).

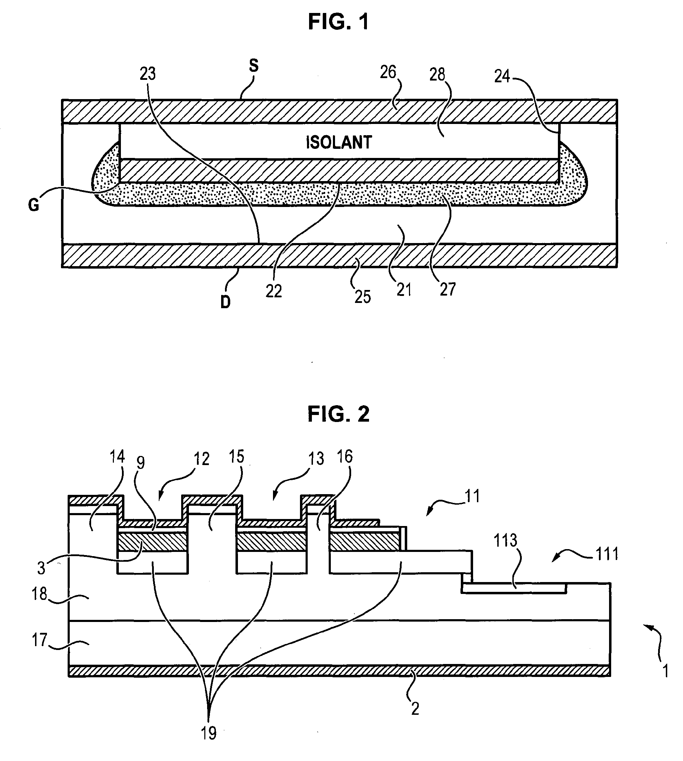

On a illustré schématiquement à la figure 1 les éléments principaux constituant un transistor à effet de champ vertical et quasi-vertical. Ce transistor comprend un substrat 21 présentant deux faces opposées dites « face avant » 22 et « face arrière » 23. Le substrat 21 comprend également au moins une tranchée 24 au niveau de sa face avant 22.

La face arrière 23 du transistor est recouverte d'une couche métallique 25 et forme le drain D du transistor.

La face avant 22 du substrat est recouverte d'une couche métallique 26 et forme la source S du transistor.

Dans le cas d'un transistor JFET, la grille est formée par implantation ionique 27 au fond de la tranchée gravée dans le substrat. Cette grille G est isolée électriquement de la source S par l'intermédiaire d'une couche 28 isolante électriquement.

Toutefois, l'implantation dans des tranchées, ainsi que d'autres étapes des procédés de fabrication de transistors JFET - telles que l'épitaxie dans les tranchées ou encore l'épitaxie sur des zones épitaxiées - sont complexes à mettre en oeuvre.

Notamment, l'étape d'implantation du substrat pour former la grille est relativement couteuse en temps et en argent puisqu'elle requière par exemple des équipements spécifiques tels que des systèmes d'implantation comportant des goniomètres permettant des implantations avec des angles contrôlés, et/ou des systèmes d'implantation permettant la mise en rotation des substrats durant l'implantation.

Par ailleurs, l'étape d'implantation a pour résultat une forte dispersion des caractéristiques électriques des composants obtenus de sorte que la répétitivité des caractéristiques électroniques des transistors JFET issus de ces procédés de fabrication est très difficile à obtenir.

US2012/104467 décrit un procédé de fabrication d'un transistor JET.

Un but de la présente invention est de proposer un procédé de fabrication de transistor JFET plus simple permettant d'améliorer le rendement de fabrication et permettant d'obtenir un meilleur taux d'intégration (augmentation de la densité de courant) que les procédés de fabrication existant, afin de réduire la taille des composants commandés et les valeurs des capacités internes des composants commandés.

Un autre but de la présente invention est fournir un composant commandé présentant une faible résistance à l'état passant, et de faibles pertes en commutation.

### RESUME DE L'INVENTION

A cet effet, l'invention propose un procédé de fabrication d'un transistor à effet de champ de type à grille en tranchée comprenant :
- La formation d'au moins une tranchée dans une couche active semi-conductrice d'un premier type de conductivité d'un substrat comprenant deux faces opposées dite face avant et face arrière,
- L'implantation primaire d'ions ayant un deuxième type de conductivité de sorte à implanter chaque tranchée du substrat pour former une zone implantée,
- Le dépôt d'une couche de silicium poly-cristallin du deuxième type de conductivité sur la zone implantée,
- L'oxydation partielle de la couche de silicium poly-cristallin pour obtenir un film isolant électriquement de silicium poly-cristallin oxydé sur une sous-couche de silicium poly-cristallin non oxydé, la sous-couche de silicium poly-cristallin et la zone implantée formant une région active de grille, et
- La métallisation du substrat sur sa face avant pour former une région active de source, et
- La métallisation du substrat sur une autre face pour former une région active de drain.

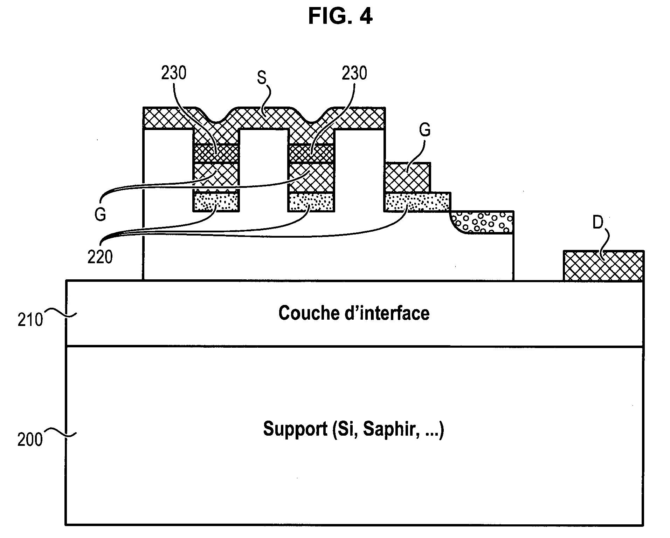

On entend, dans le cadre de la présente invention, par « substrat » une (ou plusieurs couches) de matériau tel qu'un empilement :
- d'une couche active de nitrure de gallium GaN sur une (ou plusieurs) couche(s) d'interface(s) sur une couche support (de silicium, de saphir, etc.) ; ceci permet d'obtenir un transistor quasi-vertical tel qu'illustré à la figure 4 lorsque le drain du transistor est réalisé sur la face avant de la couche support,
- d'une couche de carbure de silicium SiC sur une couche support de carbure de silicium dopé N++, ceci permet d'obtenir un transistor vertical tel qu'illustré à la figure 2.

Le fait de d'oxyder la couche de silicium poly-cristallin permet de former une couche isolante sur la couche de silicium poly-cristallin. La succession des étapes de dépôt d'une couche de silicium poly-cristallin et son oxydation permet de former la région active de grille plus efficacement qu'avec les procédés de l'art antérieur.

L'étape de formation comprend les sous-étapes de :
- Dépôt d'un masque primaire sur la face avant du substrat semi-conducteur, le masque primaire incluant une ouverture principale et deux ouvertures subsidiaires, les dimensions de l'ouverture principale étant supérieures aux dimensions des ouvertures subsidiaires,
- Gravure primaire du substrat à travers l'ouverture principale pour former une tranchée principale, et à travers les ouvertures subsidiaires pour former deux tranchées subsidiaires,
   l'étape d'implantation primaire étant réalisée à travers le masque primaire ; l'utilisation d'un même masque pour réaliser les tranchée et l'implantation permet un auto-alignement du transistor ;

- le procédé comprend en outre:
   - une étape de dépôt d'un masque de gravure secondaire sur la face avant du substrat postérieurement à l'étape d'implantation primaire, ledit masque de gravure secondaire incluant une ouverture de gravure secondaire s'étendant au droit de la tranchée principale,
   - une étape de gravure secondaire du substrat à travers l'ouverture de gravure secondaire pour former une tranchée secondaire dans la tranchée principale ;

Des aspects préférés mais non limitatifs du procédé de fabrication selon l'invention sont les suivants :
- le procédé comprend en outre une étape de retrait du masque primaire préalablement au dépôt du masque de gravure secondaire ;
- le procédé comprend en outre :
   - une étape de dépôt d'un masque d'implantation secondaire sur la face avant du substrat postérieurement à l'étape de gravure secondaire, le masque d'implantation secondaire incluant une ouverture d'implantation secondaire s'étendant au droit de la tranchée secondaire,
   - une étape d'implantation secondaire d'ions du deuxième type de conductivité à travers l'ouverture d'implantation secondaire ;
- le procédé comprend en outre le retrait du masque de gravure secondaire préalablement au dépôt du masque d'implantation secondaire ;
- le procédé comprend en outre :
   - une étape de dépôt d'un masque de gravure tertiaire sur la face avant du substrat, postérieurement à l'étape d'oxydation de la couche de silicium poly-cristallin, ledit masque de gravure tertiaire incluant une ouverture de gravure tertiaire s'étendant au droit de la tranchée secondaire,
   - la gravure du substrat à travers l'ouverture de gravure tertiaire pour éliminer le silicium poly-cristallin s'étendant sur la surface de la tranchée secondaire ;
- le substrat est du carbure de silicium ;
- l'étape d'implantation primaire comprend l'implantation d'ions à une profondeur comprise entre 0 et plus de 1µm ; dans le mode de réalisation où la profondeur d'implantation est nulle, l'étape d'implantation n'est pas mise en oeuvre ;
- chaque étape d'implantation comprend l'implantation d'ions à une dose d'implantation comprise entre 10¹² cm⁻² et 10¹⁶ cm⁻²;
- l'étape de dépôt de la couche de silicium poly-cristallin est réalisée soit par pulvérisation, soit en phase vapeur, de sorte à former une hétérojonction.

### BREVE DESCRIPTION DES DESSINS

D'autres avantages et caractéristiques du procédé selon l'invention et du produit associé ressortiront mieux de la description qui va suivre de plusieurs variantes d'exécution, données à titre d'exemples non limitatifs, à partir des dessins annexés sur lesquels :
- La figure 1 illustre un exemple de transistor à effet de champ vertical de l'art antérieur,
- La figure 2 illustre un exemple de transistor JFET vertical obtenu en mettant en oeuvre le procédé fabrication illustré à la figure 3,
- La figure 3 illustre un exemple de procédé de fabrication d'un transistor JFET,
- La figure 4 illustre un exemple de transistor JFET quasi-vertical.

### DESCRIPTION DETAILLEE DE L'INVENTION

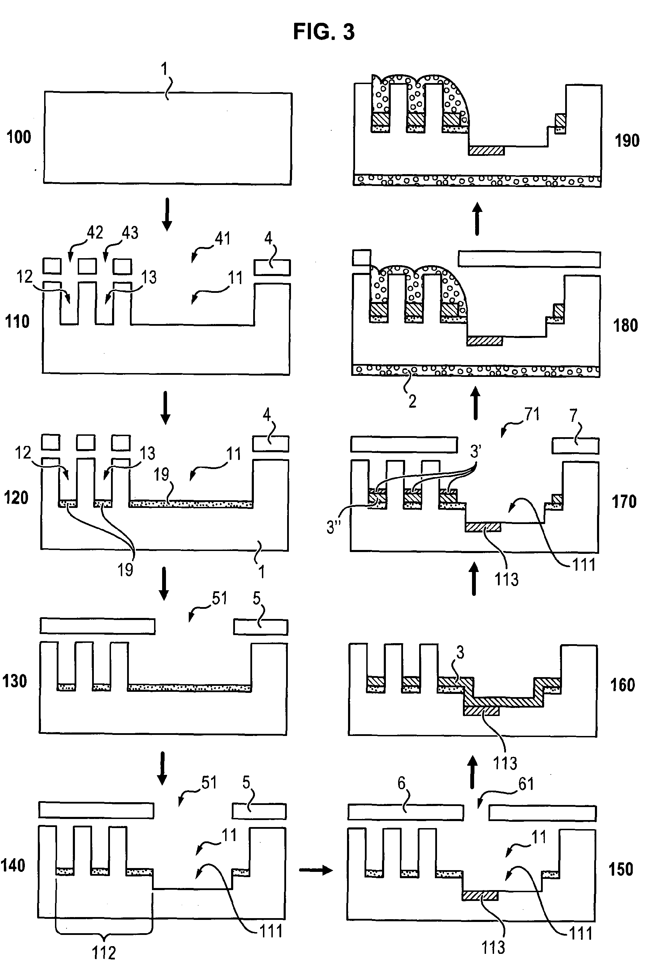

En référence à la figure 2, on a illustré un exemple de transistor JFET de type N obtenu en mettant en oeuvre le procédé de fabrication illustré à la figure 3.

Le transistor comprend un substrat 1 incluant une tranchée principale 11 et deux tranchées subsidiaires 12, 13. Ces tranchées 11, 12, 13 sont séparées par des piliers 14, 15, 16 d'une hauteur de 3µm et de largeur supérieure ou égale à 2µm, correspondant à un rapport hauteur/largeur compris entre 1 et 5.

Le substrat comprend également une tranchée secondaire 111 dans la tranchée principale 11. Cette tranchée secondaire comporte une zone 113 implantée de conductivité de type P, dite d'extension de terminaison de la jonction (ou « JTE », sigle de l'expression anglo-saxonne « *Junction Termination Extension* »). La présence de cette zone 113 implantée de type P permet d'assurer une bonne tenue en tension du transistor JFET.

Le matériau constituant le substrat 1 peut être du carbure de silicium, ou tout autre type de semi-conducteur à large bande d'énergie interdite connu de l'homme du métier. Par exemple, le matériau constituant le substrat peut être du diamant ou du nitrure de gallium (ou « GaN », acronyme de l'expression anglo-saxonne « gallium nitride »).

Le substrat 1 comporte une couche de base 17 dopée N, et une couche épitaxiée 18 dopée N sur la couche de base 17. Le substrat comprend également des régions implantées 19 de la couche épitaxiée 18 s'étendant entre les piliers 14, 15, 16. Ces régions implantées de type P forment avec les régions 3 la grille du transistor JFET.

La face arrière du substrat - correspondant à la face de la couche de base opposée à la couche épitaxiée - comporte une couche métallique 2 formant le drain du transistor JFET. La face avant du substrat comporte également une couche métallique 9 formant la source du transistor JFET.

Le transistor comprend également des couches de silicium poly-cristallin dopées 3 sur les régions implantées 19 du substrat. Avantageusement, les couches de silicium poly-cristallin peuvent être remplacées par des couches de tout au type de matériau de remplissage permettant de réaliser une hétérojonction.

La structure du transistor illustré à la figure 2 lui permet de présenter une résistance spécifique de conduction inférieure aux transistors JFET de l'art antérieur.

La topologie de la structure permet également l'intégration :
- d'une diode interne de fort calibre de courant,
- de capteurs de courant et de température.

L'intégration de capteurs de courant dans le transistor JFET illustré à la figure 2 permet de faciliter la surveillance de l'état électrique du transistor JFET afin de prédire une éventuelle dégradation de celui-ci.

Le transistor JFET illustré à la figure 2 est adapté pour un fonctionnement à haute fréquence. Il est compatible avec les applications de haute tension et moyenne température (i.e. 300°C). Il peut être utilisé pour la conception de systèmes de conversion d'énergie de type onduleur de tension, onduleur de courant ou tout autre convertisseur (DC/DC, DC/AC, multi-niveau, etc.).

La mise en oeuvre du procédé décrit précédemment permet de fabriquer un dispositif semi-conducteur à effet de champ en tranchée comprenant une électrode de commande de type mixte (hétérojonction/PN).

La figure 3 illustre schématiquement un exemple de procédé de fabrication d'un transistor JFET.

### Etape 110 de formation des tranchées

Le procédé comprend une étape 110 de formation d'une tranchée principale 11 et de deux tranchées subsidiaires 12, 13 dans un substrat 1 de carbure de silicium de conductivité de type N.

Pour ce faire, les sous-étapes suivantes sont mises en oeuvre :
- le dépôt d'un masque primaire 4, et
- la gravure du substrat à travers le masque primaire.

Le dépôt du masque primaire 4 peut être réalisé par toute technique connue de l'homme du métier. Par exemple, dans un mode de réalisation l'étape de dépôt du masque comprend :
- le dépôt d'une couche de diélectrique, tel que du nitrure de silicium, sur toute la surface du substrat, et
- la gravure de la couche de diélectrique - notamment par photolithographie - de façon à définir des ouvertures 41, 42, 43 dans la couche de diélectrique exposant des régions micrométriques de la surface du substrat.

L'homme du métier appréciera que d'autres matériaux diélectriques - tels que le SiO2 ou le TiN, etc. - peuvent être utilisés pour réaliser le masque primaire 4.

Dans le mode de réalisation illustré à la figure 3, le masque primaire 4 comprend une ouverture principale 41 et deux ouvertures subsidiaires 42, 43. Les dimensions des ouvertures subsidiaires 42, 43 sont inférieures aux dimensions de l'ouverture principale 41.

La gravure du substrat 1 est réalisée à travers les ouvertures 41, 42, 43 du masque primaire 4. La gravure du substrat 1 à travers l'ouverture principale 41 permet la réalisation d'une tranchée principale 11 de grandes dimensions. La gravure du substrat 1 à travers les ouvertures subsidiaires 42, 43 permet l'obtention de deux tranchées subsidiaires 12, 13.

La tension de seuil et la résistance spécifique du transistor JFET obtenue à la fin du procédé dépendent notamment de la largeur et de la profondeur des tranchées.

A l'issue de l'étape de formation des tranchées, le masque primaire est maintenu en position pour réaliser une étape d'implantation du substrat à travers les ouvertures du masque primaire.

### Etape 120 d'implantation ironique

L'étape d'implantation ionique 120 permet la formation de régions de grille du transistor JFET. Cette implantation ne nécessite pas une orientation particulière du substrat, contrairement aux procédés de fabrication de transistors JFET de l'art antérieur.

Dans le mode de réalisation illustré à la figure 3, les ions implantés présentent une conductivité de type P+ (le substrat ayant une conductivité de type N). Ceci permet une diminution du courant de fuite sur l'électrode de grille du transistor JFET.

La dose d'ions implantés peut être comprise entre 10¹² et 10¹⁶ cm⁻², et la profondeur d'implantation peut varier entre 1 nm et 0.2 µm en partant de la surface libre des tranchées 11, 12, 13.

L'implantation d'ions peut être mise en oeuvre lors d'une étape unique ou lors d'étapes successives. La température peut être comprise entre 4K et 1000K lors de l'étape d'implantation, selon le type de masque primaire utilisé.

Dans tous les cas, l'étape 120 d'implantation permet l'obtention de régions implantées 19 au fond des tranchées principale et subsidiaires 11, 12, 13.

### Etape de formation d'une tranchée secondaire

Le procédé comprend une étape de formation 130, 140 d'une tranchée secondaire 111 dans la tranchée principale 11 à l'issue de l'étape d'implantation 120.

Pour former la tranchée secondaire 111, les sous-étapes suivantes peuvent être mises en oeuvre :
- le dépôt d'un masque de gravure secondaire 5,
- la gravure du substrat à travers le masque de gravure secondaire 5.

Comme précédemment en référence au masque primaire 4, le dépôt du masque de gravure secondaire 5 peut être réalisé par toute technique connue de l'homme du métier (i.e. croissance d'une couche de diélectrique sur le substrat et gravure par photolithographie de cette couche pour définir une ouverture).

Dans le mode de réalisation illustré à la figure 3, le masque de gravure secondaire 5 comprend une ouverture de gravure secondaire 51.

L'ouverture de gravure secondaire 51 a des dimensions inférieures aux dimensions de l'ouverture principale 41 du masque primaire 4.

Cette ouverture de gravure secondaire 51 est positionnée au-dessus de la tranchée principale 11 pour permettre la création de la tranchée secondaire 111 dans la tranchée principale 11. Plus précisément, l'ouverture de gravure secondaire 51 est positionnée sur le substrat 1 de sorte que la projection, sur le masque de gravure secondaire 5, des bords de la tranchée principale 11 :
- entoure les bords de l'ouverture de gravure secondaire 51,
- ne soit pas en contact avec les bords de l'ouverture de gravure secondaire 51.

Dans le mode de réalisation illustré à la figure 3, le masque primaire 4 est retiré - par exemple par gravure - préalablement au dépôt du masque de gravure secondaire 5. En variante, le masque de gravure secondaire 5 peut être déposé directement sur le masque primaire 4.

Une fois le masque de gravure secondaire 5 déposé, on réalise une gravure du substrat 1 à travers l'ouverture de gravure secondaire 51. Ceci permet la réalisation d'une tranchée secondaire 111 dans la tranchée principale 11 afin de définir une structure mésa 112 ayant la forme d'un plateau surélevé.

La gravure d'une tranchée secondaire 111 dans la tranchée principale 11 permet de protéger un secteur périphérique du transistor JFET.

### Etape 150 d'implantation secondaire dans la tranchée secondaire

Le procédé peut également comprendre une étape 150 optionnelle d'implantation ionique secondaire dans la tranchée secondaire 111. Ceci permet d'améliorer la tenue en tension du transistor JFET.

Pour réaliser l'implantation secondaire de la tranchée secondaire 111, les sous-étapes suivantes sont mises en oeuvre :
- dépôt d'un masque d'implantation secondaire 6 sur le substrat 1,
- implantation ionique à travers le masque d'implantation secondaire 6.

Ici encore, le dépôt du masque d'implantation secondaire 6 peut être basé sur toute technique connue de l'homme du métier.

Dans le mode de réalisation illustré à la figure 3, le masque d'implantation secondaire 6 comprend une ouverture d'implantation secondaire 61. Cette ouverture d'implantation secondaire 61 a des dimensions inférieures aux dimensions de l'ouverture de gravure secondaire 51 du masque de gravure secondaire 5.

L'ouverture d'implantation secondaire 61 s'étendant au droit de la tranchée secondaire 111. En particulier, l'ouverture d'implantation secondaire 61 est positionnée de sorte que la projection, sur le masque d'implantation secondaire 6, des bords de la tranchée secondaire 111 entoure les bords de l'ouverture d'implantation secondaire 61 sans être en contact avec ceux-ci.

Dans le mode de réalisation illustré à la figure 3, le masque de gravure secondaire 5 est retiré préalablement au dépôt du masque d'implantation secondaire 6. En variante, le masque d'implantation secondaire 6 peut être déposé directement sur le masque de gravure secondaire 5.

On réalise ensuite une implantation ionique d'ions de conductivité de type P à travers l'ouverture d'implantation secondaire 61. La dose d'ions implantés peut être de l'ordre de 10¹⁵ cm⁻².

L'étape d'implantation secondaire induit la formation d'une zone 113 implantée de conductivité de type P dans la tranchée secondaire 111.

A l'issue de cette étape d'implantation secondaire, le masque d'implantation secondaire est retiré du substrat.

### Etape 160 de dépôt et d'oxydation d'une couche de silicium poly-cristallin

Une couche de silicium poly-cristallin 3 dopé P est ensuite déposée sur toute la surface du substrat. Cette couche de silicium poly-cristallin est conductrice électriquement.

Le dépôt 160 de la couche de silicium poly-cristallin 3 peut être réalisé par exemple par épitaxie. Cette étape 160 de dépôt aboutit à la formation d'une couche de silicium poly-cristallin dans les tranchées principale 11 et subsidiaires 12, 13 du substrat.

Puis, on met en oeuvre une étape d'oxydation de la couche de silicium poly-cristallin 3 sur une certaine épaisseur de celle-ci. Après oxydation, on obtient un film 3' de silicium poly-cristallin oxydé isolant électriquement sur une sous-couche 3" de silicium poly-cristallin dopé P non oxydée. La sous-couche de silicium poly-cristallin 3" et les régions implantées 19 forment la grille du transistor. Le film de silicium poly-cristallin oxydé 3' permet d'isoler électriquement cette grille de la source du transistor (réalisée dans une étape ultérieure du procédé).

Lors de cette étape d'oxydation, le silicium poly-cristallin se consomme et tend à disparaître. Cette consommation du silicium poly-cristallin se produit principalement au niveau des grandes surfaces de la couche de silicium poly-cristallin, et donc de manière prépondérante dans la tranchée secondaire 111 du substrat 1.

Avantageusement, l'épaisseur de la couche de silicium poly-cristallin déposée initialement (i.e. avant oxydation) est prévue de sorte que l'épaisseur restante de silicium poly-cristallin oxydé (i.e. après l'étape d'oxydation) soit sensiblement égale à 1,5µm, correspondant à environ un rapport 2/3 de la profondeur des tranchées 12 et 13.

Outre les dimensions des tranchées, la tension de seuil et la résistance spécifique du transistor JFET obtenue à la fin du procédé dépendent également de l'épaisseur de la couche de silicium poly-cristallin ainsi que la valeur de son dopage.

Ainsi, les caractéristiques électriques du transistor JFET dépendent de paramètres (i.e. largeur et profondeur des tranchées, épaisseur et dopage de la couche de silicium poly-cristallin) facilement contrôlables du procédé de fabrication illustré à la figure 3.

### Etape optionnelle de gravure du silicium poly-cristallin oxydé superflu

Dans l'hypothèse où la couche de silicium poly-cristallin oxydé n'est pas complètement consommée au niveau de la tranchée secondaire 111, le procédé peut comprendre une étape 170 supplémentaire de gravure.

Celle-ci permet de supprimer le silicium poly-cristallin oxydé restant dans la tranchée secondaire 111.

Pour ce faire, on dépose un masque de gravure tertiaire 7 sur le substrat 1. Ce masque de gravure tertiaire 7 comprend une ouverture de gravure tertiaire 71 s'étendant au droit de la tranchée secondaire 111. Les dimensions de l'ouverture de gravure tertiaire 73 sont égales à celle de la tranchée secondaire 111.

On réalise ensuite une gravure à travers l'ouverture de gravure tertiaire 73 pour consommer le silicium poly-cristallin oxydé superflu situé dans la tranchée secondaire 111.

### Etape de métallisation face avant et arrière du substrat

A la suite de l'étape de dépôt et d'oxydation de la couche de silicium poly-cristallin, une métallisation de la face arrière du substrat peut être effectuée pour former le drain du transistor JFET.

De même une étape de dépôt d'une couche métallique est réalisée sur la face avant du substrat pour former la source du transistor JFET. Cette métallisation face avant est mise en oeuvre au niveau de la structure mésa du substrat en utilisant un masque incluant une ouverture positionnée au-dessus des tranchées subsidiaires et d'une surface de la tranchée principale ne comprenant pas la tranchée secondaire 111.

Après une étape de recuit thermique rapide et deux étapes optionnelles de polissage des faces avant et arrière du substrat, on obtient le transistor JFET semblable au transistor JFET illustré à la figure 2.

Le procédé de fabrication décrit ci-dessus présente de nombreux avantages par rapport à l'état de l'art. Il permet notamment :
- une réduction du nombre d'étape de fabrication,
- une diminution significative du coût de fabrication,
- une simplification de la géométrie, de la mise à l'échelle et de la fabrication du transistor JFET,
- un meilleur contrôle de la tension de seuil du transistor JFET,
- une diminution du temps de commutation du transistor JFET entre un état passant et un état bloqué.

En référence à la figure 4, on a illustré un autre exemple de transistor obtenu en mettant en oeuvre le procédé illustré à la figure 3. Le transistor comprend un support 200 en matériau silicium ou saphir.

Il comprend également une (ou plusieurs) couche(s) intermédiaire(s) 210. La (ou les) couche(s) intermédiaire(s) comprend (comprennent) par exemple une couche de nitrure d'aluminium AIN, une couche de SiO2, une couche de nitrure de gallium aluminium AlGaN.

Le transistor comprend enfin une couche active de nitrure de gallium GaN incluant :
- des tranchées principale et subsidiaires,
- une région implantée dans chaque tranchée
- une couche de silicium poly-cristallin G dans chaque tranchée secondaire - ces couches adjacentes formant la grille du transistor,
- une couche isolante de silicium poly-cristallin oxydé sur les couches de silicium poly-cristallin formant grille G des tranchées secondaires,
- une couche métallique s'étendant sur les couches isolantes des tranchées secondaires pour former la source S.

Dans le mode de réalisation illustré à la figure 4, la couche active ne recouvre pas toute la surface de l'interface. Un plot métallique formant drain est agencé sur la région de la couche d'interface non recouverte par la couche active. Ceci permet d'obtenir un transistor quasi-vertical.

L'homme du métier aura compris que de nombreuses modifications peuvent être apportées au procédé décrit ci-dessus sans sortir matériellement des nouveaux enseignements présentés ici. Par exemple, bien que le procédé ait été décrit en référence à la fabrication d'un transistor N, il peut être utilisé pour la fabrication d'un transistor JFET de type P.

Il est donc bien évident que les exemples qui viennent d'être donnés ne sont que des illustrations particulières en aucun cas limitatives.

## Revendications

1. Procédé de fabrication d'un transistor à effet de champ de type à grille en tranchée comprenant :
- La formation (110) d'au moins une tranchée (11, 12, 13) dans une couche active semi-conductrice (1) d'un premier type de conductivité d'un substrat comprenant deux faces opposées dite face avant et face arrière,
- L'implantation primaire (120) d'ions ayant un deuxième type de conductivité de sorte à implanter chaque tranchée du substrat pour former une région active de grille,
- Le dépôt (160) d'une couche de silicium poly-cristallin du deuxième type de conductivité sur la région active de grille implantée,
- L'oxydation partielle (160) de la couche de silicium poly-cristallin pour obtenir un film (3') isolant électriquement de silicium poly-cristallin oxydé sur une sous-couche de silicium poly-cristallin non oxydé, la sous-couche de silicium poly-cristallin et la zone implantée formant une région active de grille, et
- La métallisation (180) du substrat sur sa face avant pour former une région active de source, et
- La métallisation (180) du substrat sur une autre face pour former une région active de drain,
ledit procédé étant **caractérisé en ce que** l'étape de formation comprend les sous-étapes de :
- Dépôt d'un masque primaire (4) sur la face avant du substrat semi-conducteur, le masque primaire incluant une ouverture principale (41) et deux ouvertures subsidiaires (42, 43), les dimensions de l'ouverture principale étant supérieures aux dimensions des ouvertures subsidiaires,
- Gravure primaire du substrat à travers l'ouverture principale pour former une tranchée principale (11), et à travers les ouvertures subsidiaires pour former deux tranchées subsidiaires (12, 13),
l'étape d'implantation primaire étant réalisée à travers le masque primaire, et **en ce que** le procédé comprend en outre :
- une étape (130) de dépôt d'un masque de gravure secondaire (5) sur la face avant du substrat postérieurement à l'étape d'implantation primaire, ledit masque de gravure secondaire incluant une ouverture de gravure secondaire (51) s'étendant au droit de la tranchée principale (11),
- une étape (140) de gravure secondaire du substrat à travers l'ouverture de gravure secondaire (51) pour former une tranchée secondaire (111) dans la tranchée principale (11).

2. Procédé de fabrication selon la revendication 1, lequel comprend en outre une étape de retrait du masque primaire (4) préalablement au dépôt du masque de gravure secondaire (5).

3. Procédé de fabrication selon l'une quelconque des revendications 1 ou 2, lequel comprend en outre :
- une étape (150) de dépôt d'un masque d'implantation secondaire (6) sur la face avant du substrat postérieurement à l'étape de gravure secondaire (140), le masque d'implantation secondaire (6) incluant une ouverture d'implantation secondaire (61) s'étendant au droit de la tranchée secondaire (111),
- une étape (150) d'implantation secondaire d'ions du deuxième type de conductivité à travers l'ouverture d'implantation secondaire (61).

4. Procédé de fabrication selon la revendication 3, lequel comprend en outre le retrait du masque de gravure secondaire (5) préalablement au dépôt du masque d'implantation secondaire (6).

5. Procédé de fabrication selon l'une quelconque des revendications 1 à 4, lequel comprend en outre :
- une étape (170) de dépôt d'un masque de gravure tertiaire (7) sur la face avant du substrat, postérieurement à l'étape d'oxydation (160) de la couche de silicium poly-cristallin (3), ledit masque de gravure tertiaire (7) incluant une ouverture de gravure tertiaire (71) s'étendant au droit de la tranchée secondaire (111),
- la gravure (170) du substrat à travers l'ouverture de gravure tertiaire (71) pour éliminer le silicium poly-cristallin s'étendant sur la surface de la tranchée secondaire (111).

6. Procédé de fabrication selon l'une des revendications 1 à 5, dans lequel le substrat (1) est du carbure de silicium.

7. Procédé de fabrication selon l'une quelconque des revendications 1 à 6, dans lequel l'étape (120) d'implantation primaire comprend l'implantation d'ions à une profondeur comprise entre 1 nm et 1 µm.

8. Procédé de fabrication selon l'une quelconque des revendications 1 à 7, dans lequel chaque étape (120, 150) d'implantation comprend l'implantation d'ions à une dose d'implantation comprise entre 10¹² cm⁻² et 10¹⁶ cm⁻².

9. Procédé de fabrication selon l'une des revendications précédentes, dans lequel l'étape de dépôt de la couche de silicium poly-cristallin est réalisée soit par pulvérisation, soit en phase vapeur, de sorte à former une hétérojonction.

## Patentansprüche

1. Herstellungsverfahren eines Feldeffekttransistors vom Typ mit Graben-Gate, umfassend:
- das Bilden (110) mindestens eines Grabens (11, 12, 13) in einer aktiven halbleitenden Schicht (1) eines ersten Konduktivitätstyps eines Substrats, umfassend zwei gegenüberliegende Seiten, eine Vorder- und eine Rückseite,
- die Primärimplantation (120) von Ionen mit einem zweiten Konduktivitätstyp, so dass jeder Graben des Substrats implantiert wird, um eine aktive Gate-Region zu bilden,
- der Abscheidung (160) einer Schicht polykristallinen Siliziums des zweiten Konduktivitätstyps auf die implantierte aktive Gate-Region,
- die teilweise Oxidation (160) der Schicht polykristallinen Siliziums, um einen elektrisch isolierenden Film (3') aus oxidiertem polykristallinem Silizium auf einer Unterschicht aus nicht oxidiertem polykristallinem Siliziums zu erhalten, wobei die Unterschicht aus polykristallinem Silizium und die implantierte Zone eine aktive Gate-Region bilden, und
- die Metallisierung (180) des Substrats auf seiner Vorderseite, um eine aktive Quellenregion zu bilden, und
- die Metallisierung (180) des Substrats auf einer anderen Seite, um eine aktive Drainregion zu bilden,
wobei das Verfahren **dadurch gekennzeichnet, ist, dass** der Schritt des Bildens die folgenden Unterschritte umfasst.
- Abscheidung einer primären Maske (4) auf die Vorderseite des halbleitenden Substrats, wobei die primäre Maske eine Hauptöffnung (41) und zwei subsidiäre Öffnungen (42, 43) aufweist, wobei die Abmessungen der Hauptöffnung größer sind als die Abmessungen der subsidiären Öffnungen,
- primäre Gravur des Substrats durch die Hauptöffnung, um einen Hauptgraben (11) zu bilden, und durch die subsidiären Öffnungen, um zwei subsidiäre Gräben (12, 13) zu bilden, wobei der Schritt der Primärimplantation durch die primäre Maske durchgeführt wird,
und dass das Verfahren ferner umfasst:
- einen Schritt (130) der Abscheidung einer sekundären Gravurmaske (5) auf die Vorderseite des Substrats nach dem Schritt der Primärimplantation, wobei die sekundäre Gravurmaske eine sekundäre Gravuröffnung (51) aufweist, die sich über dem Hauptgraben (11) erstreckt,
- einen sekundären Gravurschritt (140) des Substrats durch die sekundäre Gravuröffnung (51), um einen sekundären Graben (111) im Hauptgraben (11) zu bilden.

2. Herstellungsverfahren nach Anspruch 1, welches ferner einen Entfernungsschritt der primären Maske (4) vor der Abscheidung der sekundären Gravurmaske (5) umfasst.

3. Herstellungsverfahren nach einem der Ansprüche 1 oder 2, welches ferner umfasst:
- einen Schritt (150) der Abscheidung einer sekundären Implantationsmaske (6) auf die Vorderseite des Substrats nach dem sekundären Gravurschritt (140), wobei die sekundäre Implantationsmaske (6) eine sekundäre Implantationsöffnung (61) aufweist, die sich über dem sekundären Graben (111) erstreckt,
- einen sekundären Implantationsschritt (150) von Ionen des zweiten Konduktivitätstyps durch die sekundäre Implantationsöffnung (61).

4. Herstellungsverfahren nach Anspruch 3, welches ferner das Entfernen der sekundären Gravurmaske (5) vor der Abscheidung der sekundären Implantationsmaske (6) umfasst.

5. Herstellungsverfahren nach einem der Ansprüche 1 bis 4, welches ferner umfasst:
- einen Schritt (170) der Abscheidung einer tertiären Gravurmaske (7) auf die Vorderseite des Substrats nach dem Oxidationsschritt (160) der Schicht polykristallinen Siliziums (3), wobei die tertiäre Gravurmaske (7) eine tertiäre Gravuröffnung (71) aufweist, die sich über dem sekundären Graben (111) erstreckt,
- die Gravur (170) des Substrats durch die tertiäre Gravuröffnung (71), um das polykristalline Silizium zu entfernen, das sich auf der Oberfläche des sekundären Grabens (111) erstreckt.

6. Herstellungsverfahren nach einem der Ansprüche 1 bis 5, wobei das Substrat (1) Siliziumkarbid ist.

7. Herstellungsverfahren nach einem der Ansprüche 1 bis 6, wobei der Schritt der Primärimplantation (120) eine Implantation von Ionen in einer Tiefe zwischen 0 und 1 µm inklusive umfasst.

8. Herstellungsverfahren nach einem der Ansprüche 1 bis 7, wobei jeder Implantationsschritt (120, 150) die Implantation von Ionen in einer Implantationsdosis zwischen 10¹² cm⁻² und 10¹⁶ cm⁻² inklusive umfasst.

9. Herstellungsverfahren nach einem der vorangehenden Ansprüche, wobei der Schritt der Abscheidung der Schicht aus polykristallinem Silizium entweder durch Zerstäuben oder in der Dampfphase durchgeführt wird, um einen Heteroübergang zu bilden.

## Claims

1. A manufacturing method of a field-effect transistor of trench gate type, comprising:
- formation (110) of at least one trench (11, 12, 13) in an active semi-conductive layer (1) of a first type of conductivity of a substrate comprising two opposite faces called front face and rear face,
- primary implantation (120) of ions having a second type of conductivity so as to implant each trench of the substrate to form an active gate region,
- deposit (160) of a layer of poly-crystalline silicon of the second type of conductivity on the implanted active gate region,
- partial oxidation (160) of the layer of poly-crystalline silicon to obtain an electrically insulating film (3') of oxidized poly-crystalline silicon on a sub-layer of non-oxidized poly-crystalline silicon, the sub-layer of poly-crystalline silicon and the implanted area forming an active gate region, and
- metallization (180) of the substrate on its front face to form an active source region, and
- metallization (180) of the substrate on another face to form an active drain region,
said method being **characterized in that** the formation step comprises the sub-steps of:
- depositing a primary mask (4) on the front face of the semiconductive substrate, the primary mask including a principal opening (41) and two subsidiary openings (42, 43), the dimensions of the principal opening being greater than the dimensions of the subsidiary openings,
- primary etching of the substrate through the principal opening to form a principal trench (11), and through the subsidiary openings to form two subsidiary trenches (12, 13),
the primary implantation step being done through the primary mask,
and **in that** the method further comprises:
- a deposit step (130) of a secondary etching mask (5) on the front face of the substrate following the primary implantation step, said secondary etching mask including a secondary etching opening (51) extending above the principal trench (11),
- a secondary etching step (140) of the substrate through the secondary etching opening (51) to form a secondary trench (111) in the principal trench (11).

2. The manufacturing method according to claim 1, which further comprises a step for removing the primary mask (4) prior to depositing of the secondary etching mask (5).

3. The manufacturing method according to any one of claims 1 or 2, which further comprises:
- a deposit step (150) of a secondary implantation mask (6) on the front face of the substrate following the secondary etching step (140), the secondary implantation mask (6) including a secondary implantation opening (61) extending above the secondary trench (111),
- a secondary ion-implantation step (150) of the second type of conductivity through the secondary implantation opening (61).

4. The manufacturing method according to claim 3, which further comprises the removal of the secondary etching mask (5) prior to depositing of the secondary implantation mask (6).

5. The manufacturing method according to any one of claims 1 to 4, which further comprises:
- a deposit step (170) of a tertiary etching mask (7) on the front face of the substrate, following the oxidation step (160) of the layer of poly-crystalline silicon (3), said tertiary etching mask (7) including a tertiary etching opening (71) extending above the secondary trench (111),
- etching (170) of the substrate through the tertiary etching opening (71) to eliminate the poly-crystalline silicon extending over the surface of the secondary trench (111).

6. The manufacturing method according to any one of claims 1 to 5, wherein the substrate (1) is silicon carbide.

7. The manufacturing method according to any one of claims 1 to 6, wherein the primary implantation step (120) comprises the implantation of ions at a depth of between 1 nm and 1 µm.

8. The manufacturing method according to any one of claims 1 to 7, wherein each implantation step (120, 150) comprises the implantation of ions at an implantation dose of between 10¹² cm⁻² and 10¹⁶ cm⁻².

9. The manufacturing method according to any one of the preceding claims, wherein the step for deposit of the layer of poly-crystalline silicon is done either by pulverisation or in the steam phase to form a heterojunction.
